# EUROPEAN PATENT SPECIFICATION

(11) **EP 4 158 079 B1**
(45) Date of publication and mention of the grant of the patent: **27.05.2026**
(21) Application number: 21813602.6
(22) Date of filing: 23.04.2021
(51) Int. Cl.: C23C 18/44, C23C 18/36, C23C 18/16, C23C 18/54, H05K 3/24

(54) **GOLD PLATING BATH AND GOLD PLATED FINAL FINISH**
GOLDPLATTIERUNGSBAD UND GOLDPLATTIERTE ENDBEARBEITUNG
BAIN DE PLACAGE D'OR ET FINITION DÉFINITIVE PLAQUÉE OR

(30) Priority: 27.05.2020 US 202016884314
(43) Date of publication of application: 05.04.2023
(73) Proprietor: MacDermid Enthone Inc., Waterbury, CT 06702 (US)
(72) Inventor: BERNARDS, Roger, Goshen, Connecticut 06756 (US); ABEL-TATIS, Emely, Bethel, Connecticut 06801 (US)
(74) Representative: Novagraaf Group
(86) International application number: PCT/US2021/028899
(87) International publication number: WO 2021/242458

(56) References cited:
- JP-A- 2004 137 589
- US-A- 5 803 957
- US-A1- 2007 095 249
- US-A1- 2008 138 507
- KJELL ET AL.: "A Novel, Nonaqueous Method for Regeneration of Aldehydes from Bisulfite Adducts", JOURNAL OF ORGANIC CHEMISTRY, vol. 64, 7 February 1999 (1999-02-07), pages 5722 - 5724, XP003013995, DOI: 10.1021/jo990543v

## Description

### FIELD OF THE INVENTION

The present invention relates generally to a final gold surface treatment to increase solderability of a circuit board or IC substrate.

### BACKGROUND OF THE INVENTION

Surface treatments are used to provide improved connectivity. One example of a surface treatment involves gold plating, which is most suitable for final surface treatment of printed circuit boards. It has excellent physical properties such as electrical conductivity, chemical resistance and oxidation resistance of gold as well as solder mounting reliability when mounting electronic components. Nickel plating is typically used as the base metal of electroless gold plating. The surface finish/treatment either protects or forms the connection from the board to a device. Methods in which electroless gold plating is performed after electroless nickel plating is performed on a copper wiring of a printed circuit board include, but not limited to, the following:
a) Electroless Ni/Immersion Au (ENIG);
b) Electroless Ni/Autocatalytic Au (ENAG);
c) Electroless Ni/Immersion Au/Autocatalytic Au (ENIGAG);
d) Electroless Ni/Electroless Pd/Immersion Au (ENEPIG);
e) Direct Au over Cu; and
f) Au over Ag.

As manufacturing and development of electronic components and semiconductor parts continues to advance, improvements in plating techniques are also required. For example, a plating technique may be used to form a circuit pattern on a substrate using a metal such as copper having low electrical resistance when manufacturing a semiconductor package, following by nickel plating, palladium plating, and gold plating to form a joined part.

Electroless nickel/immersion gold plating processes are frequently used for surface treatment for applications that require high reliability in mounting processes of printed circuit boards or electronic parts. For example, in electroless nickel/immersion gold, the immersion gold layer protects the underlying electroless nickel plating from oxidation.

Furthermore, a nickel plated coating film is often used as a barrier film for preventing erosion of a copper circuit caused by solder. Thereafter, a palladium-plated film may be used as a barrier film for preventing diffusion of the nickel plated coating film to a gold plated coating film. Since the gold plated coating film has low electrical resistance and good solder wettability, the gold coated plating film may be applied to the final finish to produce a joined part having excellent joining properties, including solderability and/or wire joining, with a plated coating film comprising a plated coating film made of an underlying metal such as nickel and/or palladium and the gold plated film.

**In** addition, it is known to subject an underlying metal such as palladium to immersion gold plating to secure adhesion between the plated coating film and the underlying metal. However since the immersion gold plating stops the reaction when the underlying metal is wholly substituted, the immersion gold plating can limit the thickness of the gold plating layer being formed. On the other hand, formation of a thick gold plated coating film may be required for certain portions joined with wire bonding. **In** order to form the thick gold plated coating film, gold plate processing is performed which requires two steps of subjecting the underlying metal to immersion gold plating processing to secure adhesion and then further subjecting the underlying metal to reduction-type electroless gold plating.

A plate processing operation itself may also be complicated by subjecting the underlying metal such as palladium to immersion gold plate processing and then subjecting the underlying metal to reduction type electroless gold plate processing. The immersion gold plate processing deposits gold using the difference between the oxidation reduction potential of the plated coating film and the underlying metal. The immersion gold plate processing may partially form severe corrosion of the underlying metal. Electroless gold plating baths can suppress the corrosion of the underlying metal, however, there can be issues related to stability of the electroless gold plating bath, resulting in plating deficiencies and unfavorable appearance of the plated gold.

In immersion gold plating, gold is deposited using a difference in redox potential between an underlying nickel layer and a plating bath, so that gold dissolves the nickel thereby corroding the nickel. In addition, diffusion of nickel over the gold film takes place, thereby lowering wire bondability. To avoid this, reduction gold plating may be further performed on the electroless nickel/immersion gold plating films to make a thick gold film thereby suppressing the wire bondability from lowering, but with a problem of costs.

Due in part to the desirability of using lead-free solders, there has been a trend toward the use of Sn-Ag-Cu solder. However, a greater thermal load is needed upon solder bonding when compared with conventional tin-lead eutectic solders, with the attendant problem that bonding characteristics lower. To avoid this problem, a method has been developed that sandwiches a palladium film between the electroless nickel plating layer and the immersion gold plating layer by electroless palladium plating.

Autocatalytic and electroless gold plating baths tend to be unstable, resulting in precipitation of expensive gold salts and gold metal in the plating solution. Thus, it would be desirable to avoid this instability through careful selection of additives used to stabilize the gold plating solution.

U.S. Pat. No. 8,124,174 to Kurosaka et al. describes an electroless gold plating bath that includes a water-soluble gold compound, a complexing agent, formaldehyde and/or a formaldehyde bisulfite adduct, and an amine compound. However, the use of formaldehyde and/or a formaldehyde bisulfite adduct has been found to inherently cause instability of the gold plating bath.

Thus, it would be desirable to discover other reducing agents that do not cause instability of the gold plating bath. In other words, it would be desirable to provide a gold plating bath that exhibits improved stability and reduced corrosion, and that can preserve solderability of the deposit.

US 2008/0138507 A1 discloses an electroless gold plating bath which includes a water-soluble gold compound, a complexing agent, an aldehyde compound, and an amine compound.

US 5,803,957 discloses an electroless gold plating bath comprising a water-soluble gold compound, a complexing agent, a reducing agent, and polyvinyl pyrrodidone.

US 2007/0095249 A1 discloses an electroless gold plating liquid comprising a noncyanide gold salt, an alkali metal salt or an ammonium salt of sulfurous acid and thiosulfuric acid as a metal complexing agent, a hydroxyalkylsulfonic acid or a salt thereof as a reducing agent, and an amine compound.

### SUMMARY OF THE INVENTION

It is an object of the present invention to provide an electroless gold plating bath capable of providing a gold plating layer or film on an underlying substrate.

It is another object of the present invention to provide an electroless gold plating bath capable of providing a gold plating layer on an underlying nickel or palladium plated layer.

It is another object of the present invention to provide a gold plating layer that exhibits increased solderability of a final circuit board.

It is still another object of the present invention to provide a gold plating layer that exhibits good conductivity of an electrical contact interface.

It is still another object of the present invention to provide a gold plating bath that provides good stability.

It is still another object of the present invention to provide a gold plating bath that does not precipitate gold or gold salts.

To that end, in one aspect, the present invention provides an autocatalytic gold plating bath according to claim 1.

In another aspect, the present invention provides a method of providing a gold finish on a substrate by autocatalytic gold plating, according to claim 7.

Certain more specific aspects of the invention are set out in the dependent claims.

### DETAILED DESCRIPTION

The inventors of the present invention have unexpectedly discovered that the use of reducing agents of higher molecular weight and containing additional carbon and/or oxygen atoms attached to the reducing agent can produce a gold plating bath that exhibits greater stability towards plate out and precipitation of gold and gold salts than the previously described formaldehyde and formaldehyde adducts. In one embodiment, the gold plating bath described herein can increase the solderability of a final circuit board. Thus, by using the gold plating bath described herein, a final finish coating can be applied to an underlying metal layer (such as electroless gold or electroless palladium) to preserve solderability.

As used herein, "a," "an," and "the" refer to both singular and plural referents unless the context clearly dictates otherwise.

As used herein, the term "about" refers to a measurable value such as a parameter, an amount, a temporal duration, and the like and is meant to include variations of +/-15 % or less, preferably variations of +/-10 % or less, more preferably variations of +/-5 % or less, even more preferably variations of +/-1 % or less, and still more preferably variations of +/-0.1 % or less of and from the particularly recited value, in so far as such variations are appropriate to perform in the invention described herein. Furthermore, it is also to be understood that the value to which the modifier "about" refers is itself specifically disclosed herein.

As used herein, spatially relative terms, such as "beneath", "below", "lower", "above", "upper" and the like, are used for ease of description to describe one element or feature's relationship to another element(s) or feature(s) as illustrated in the figures. It is further understood that the terms "front" and "back" are not intended to be limiting and are intended to be interchangeable where appropriate.

As used herein, the terms "comprises" and/or "comprising," specify the presence of stated features, integers, steps, operations, elements, and/or components, but do not preclude the presence or addition of one or more other features, integers, steps, operations, elements, components, and/or groups thereof.

As used herein the term "substantially-free" or "essentially-free" if not otherwise defined herein for a particular element or compound means that a given element or compound is not detectable by ordinary analytical means that are well known to those skilled in the art of metal plating for bath analysis. Such methods typically include atomic absorption spectrometry, titration, UV-Vis analysis, secondary ion mass spectrometry, and other commonly available analytically methods.

One aspect of the present invention relates provides an autocatalytic gold bath according to claim 1, for depositing gold from solution onto a surface through immersion deposition and/or electroless deposition.

The gold plating bath described herein generally comprises:
A) a chelator;
B) a gold salt; and
C) a reducing agent, wherein the reducing agent comprises an organic molecule having more than one carbon atom on the organic molecule. The chelator, gold salt, and reducing agent are defined more specifically in claim 1.

The chelator or complexing agent is selected from phosphoric acid, boric acid, Rochelle salt, citric acid, gluconic acid, tartaric acid, lactic acid, malic acid, ethylenediamine, triethanolamine, ethylenediamine tetraacetic acid, nitrilotriacetic acid, diethylenetriamine pentaacetic acid, hydroxyethylethylenediamine triacetic acid, triethylenetetramine hexaacetic acid, 1,3-propanediamine tetraacetic acid, 1,3-diamino-2-hydroxypropane tetraacetic acid, hydroxyethylimino diacetic acid, dihydroxyl glycine, glycol ether diamine tetraacetic acid, dicarboxymethyl glutamic acid, hydroxyethylidene diphosphoric acid, ethylenediamine tetra(methylenephosphoric acid), alkali metal (e.g. sodium or potassium) salts, alkaline earth metal salts and ammonium salts thereof. These complexing agents may be used alone or in combination. In one preferred embodiment, the chelator or complexing agent is ethylenediamine tetraacetic acid or a salt thereof. In another preferred embodiment, the complexing agent comprises one or more of ethylenediamine tetraacetic acid, malic acid, or alkaline earth metal or ammonium salts thereof, even more preferably, the complexing agent may comprise a combination of ethylenediamine tetraacetic acid, sodium salt and sodium malate.

The chelator or complexor may be used in the gold plating bath at a concentration of between about 2.0 to about 100 g/L, more preferably about 5 to about 75 g/L, most preferably about 10 to about 50 g/L.

When the concentration is below this range, the deposition rate may slow due to metal dissolving out. In addition, concentrations above this range do not provide any addition benefits to the function of the plating bath.

The gold salt is a water soluble gold salt, more specifically a gold cyanide, such as potassium gold cyanide, sodium gold cyanide, ammonium gold cyanide and the like. Other water soluble gold salts include sulfites, sulfates, thiosulfates, thiocyanates, nitrates, methane sulfonates, tetraamine complexes, chlorides, bromides, iodides, hydroxides, oxides, and the like of gold. It is also noted that these water soluble gold salts can be used alone or in combination with each other. In one preferred embodiment, the gold salt is potassium gold cyanide.

The water soluble gold salt may be used in the composition at a concentration of between about 0.5 to about 5.0 g/L, more preferably about 0.2 to about 3.0 g/L, and most preferably at a concentration of between about 0.5 and about 1.5 g/L.

The pH of the electroless gold plating bath of the present invention is preferably in the range of about 5 to about 10, more preferably about 6 to about 9, most preferably, about 8.0. When the pH is less than the recited range, the deposition rate can slow, while above the recited range, the plating bath may destabilize. Based thereon, if needed, a pH adjuster can be added to the gold plating solution. Suitable pH adjusters include, but are not limited to, sodium hydroxide, potassium hydroxide, ammonia, sulfuric acid, phosphoric acid, boric acid and other similar compounds that are usable in autocatalytic or electroless gold plating baths.

The electroless gold plating bath is typically maintained at an elevated temperature, such as a temperature within the range of about 60 to about 100° C, more preferably in the range of about 70 to about 95° C., most preferably at a temperature of between about 80 to about 88° C.

The reducing agent usable in the gold plating bath of the invention is selected from 2-methoxybenzaldehyde sodium bisulfite addition compound, acetone sodium bisulfite addition compound, P-anisaldehyde sodium bisulfite addition compound, glutaraldehyde bisulfite addition compound, and combinations of one or more of the foregoing.

The inventors of the present invention have also found that formaldehyde or bisulfite addition compounds of formaldehyde do not provide a stable bath composition and thus formaldehyde and formaldehyde bisulfite addition compounds are not usable in the baths of the present invention and are specifically excluded from the compositions and processes described herein. That is, aldehydes usable in the practice of the instant invention must contain two or more carbon atoms.

The aldehyde bisulfite addition compounds usable in the present invention include p-anisaldehyde bisulfite, sodium salt, and 2-methoxy benzaldehyde bisulfite, sodium salt. The bialdehyde bisulfite addition compounds usable in the present invention may be glutaraldehyde, sodium salt. The ketone bisulfite addition compound usable in the practice of the instant invention is acetone bisulfite, sodium salt.

While the addition compounds described above comprise sodium salts, potassium salts and ammonium salts of bisulfite addition compounds would also be usable.

The concentration of the reducing agent is typically within the range of about 0.5 to about 25 g/L, more preferably about 1 to about 20 g/L, most preferably within the range of about 3 to about 10 g/L.

In one embodiment, the gold plating bath also comprises an amine. Example of suitable amines include, but are not limited to, alkyl amine containing an amino group such as butyl amine, pentyl amine, hexyl amine, heptyl amine, octyl amine, nonyl amine, decyl amine, undecyl amine, dodecyl amine, tridecyl amine, tetradecyl amine, pentadecyl amine, hexadecyl amine, heptadecyl amine, octadecyl amine, nonadecyl amine, or eicodecyl amine. In addition, the compound having an amino group may have a branched structure. Other suitable amines are described, for example, in U.S. Pat. No. 8,124,174 to Kurosaka et al. and in U.S. Pat. No. 8,771,409 to Asakawa et al.. In one embodiment, the amine is selected from the group consisting of ethylenediamine, diethylenetriamine, triethylenetetramine, pentaethylenehexamine, and combinations of one or more of the foregoing.

If used, the amine is used in the plating bath at a concentration of between about 0.1 and about 100 g/L, more preferably at a concentration of between about 0.5 and about 10 g/L.

In one embodiment, the molar ratio between the reducing agent and the amine compound is preferably in the range of about 1:30 to about 3:1, more preferably 1:10 to 1:1.

If desired, the gold plating bath may also contain other suitable additives including, but not limited to surfactants, crystallization modifiers, buffers, flattening agents, thickness controlling agents, antifoaming agents, and other similar compounds.

In one preferred embodiment, the gold plating bath is subjected to mild agitation such as by stirring. In addition, the bath may be subjected to periodic or continuous filtration.

The gold electroplating bath may be periodically or continuously monitored to maintain the concentration of the constituents within the desired range.

As described herein, in one embodiment, the gold plating bath described herein is used to produce a final finish to an underlying metal layer such as in an ENIG, ENEPIG, EPAG, direct gold over copper or gold over silver process.

Thus, the present invention is usable in the printed circuit board industry as a final finish to the metals on the circuit board to preserve solderability. The final finish allows the circuit boards to be successfully soldered with components, especially surface mounted components.

In one embodiment, the present invention is used as a final finish in an electroless nickel immersion gold (ENIG) or electroless nickel electroless platinum immersion gold (ENEPIG) process.

The invention described herein provides an immersion and/or autocatalytic gold bath that exhibits improved stability and reduced plate out as compared with gold plating baths of the prior art.

In another aspect, the present invention also relates generally to a method as defined in claim 7 of providing a gold final finish on a substrate.

As described herein, the gold plating bath described herein can be used as a final finish over a variety of underlying metals. Based thereon, in one embodiment, the substrate comprises a metal layer, preferably a plating film deposited on the substrate. In one embodiment, the substrate comprises a circuit board or IC substrate with a metal film deposited thereon. The deposited metal film may be EN, ENEP, ENIP, by way of example and not limitation.

The substrate with the metal layer thereon is preferably contacted with the gold plating bath by immersing the substrate in the gold plating bath for a period of time sufficient to achieve the desired thickness. In one embodiment, the desired thickness is a thickness that is sufficient to increase the solderability of metal film stack. In one embodiment, the desired thickness is in the range of about 0.001 to about 40 µm, more preferably about 0.01 to about 10 µm, most preferably about 0.05 to about 1 µm. The plating time is simply the time required to achieve the desired thickness.

In an ENIG plating process, a catalytic electroless nickel plating film is deposited on an underlying substrate by known electroless nickel processes.

When the electroless nickel plating film is deposited on a surface to be plated (e.g. a surface of a copper substrate) through a catalyst, a metal serving as the catalyst includes nickel, cobalt, iron, silver, gold, ruthenium, palladium, platinum or the like, of which palladium is preferred. The deposition amount of the catalyst may be one sufficient for activation to an extent that an electroless nickel film is deposited on the surface to be plated.

In one embodiment, the electroless nickel plating bath comprises a water-soluble nickel salt, a reducing agent and a complexing agent. Suitable water-soluble nickel salts include nickel sulfate and nickel chloride. Suitable reducing agents include hypophosphorous acid such as hypophosphite or sodium hypophosphite, dimethylamine borane, trimethylamine borane, hydrazine or similar compounds. Complexing agents include carboxylic acids such as malic acid, succinic acid, lactic acid, or citric acid, sodium salts thereof, and amino acids such as glycine, alanine, iminodiacetic acid, arginine or glutamic acid. In other embodiment, the electroless nickel bath also contains a sulfur compound.

The electroless nickel plating film formed should preferably have a thickness of from 0.1 to 20 µm, more preferably from 1 to 15 µm. When the thickness is smaller than 0.1 µm, there is concern that wire bondability lowers. Over 20 µm, it takes a long plating time, with the possibility that productivity becomes worsened, thus being disadvantageous in cost.

In an ENEPIG plating process, the catalytic electroless nickel plating film has deposited thereon an electroless palladium plating film.

The electroless palladium plating film can be deposited from various baths, including an immersion type, a reduction type (a formic acid bath, a hypophosphite bath, or a phosphite bath) or other similar type bath. In one embodiment, it is preferred to form a plating film in an electroless palladium plating bath, which is characterized by including, for example, a palladium compound, at least one compound selected from ammonia and amine compounds for use as a complexing agent, at least one hypophosphorous acid compound selected from hypophosphorous acid and hypophosphites for use as a reducing agent, and at least one unsaturated carboxylic acid compound selected from unsaturated carboxylic acids, unsaturated carboxylic anhydrides, unsaturated carboxylic acid salts and unsaturated carboxylic acid derivatives.

The palladium compound may be any of those compounds that are soluble in water and include, for example, palladium chloride, palladium sulfate, palladium acetate, palladium nitrate, tetraamine palladium chloride and the like. The palladium bath may also contain at least one ingredient selected from hypophosphorous acid and hypophosphites as a reducing agent. In addition, at least one of ammonia and an amine compounds may be contained in the composition as a complexing agent. The electroless palladium plating bath may also include at least one unsaturated carboxylic acid compound selected from unsaturated carboxylic acids, unsaturated carboxylic anhydrides, unsaturated carboxylic acid salts, and unsaturated carboxylic acid derivatives.

The electroless palladium plating bath has preferably a pH of from 4 to 10, more preferably from 6 to 8. The thickness of the electroless palladium plating film is preferably in the range from 0.001 to 1.0 µm, more preferably from 0.01 to 0.3 µm. The pH of the solution may be adjusted by adding a suitable pH adjuster.

Unlike a conventional immersion gold plating bath, the electroless gold plating bath of the invention is an electroless gold plating bath of the substitution-reduction type wherein both substitution reaction and reduction reaction proceed in the same plating bath. Since the aldehyde and/or aldehyde bisulfite adduct and the amine compound represented by the general formula (1) or (2) and having a specific type of structure are contained in the gold plating bath, the electroless gold plating bath of the invention allows not only gold to be deposited on an underlying metal by the substitution reaction, but also gold to be further deposited by means of a reducing agent through the initially deposited gold as a catalyst.

The electroless gold plating bath of the invention allows a palladium surface to be activated and gold to be deposited by means of a reducing agent while using the palladium as a catalyst. Gold can be further deposited using the once deposited gold as a catalyst, so that the gold plating film can be thickened on the palladium.

When the electroless gold plating bath of the invention is brought into contact with a palladium plating film, the surface of the palladium plating film can be subjected to electroless gold plating treatment. In this case, a 0.01 to 2 µm thick of gold plating film can be formed in a contact time, for example, of 5 to 60 minutes. The gold plating film can be formed at a deposition rate, for example, of 0.002 to 0.03 µm/minute.

The present invention will now be illustrated with reference to the following nonlimiting examples:

### Example 1:

Circuit board test parts containing a 25 µm layer of copper were plated in an electroless nickel bath (Affinity 1.0, from MacDermid, Inc.) to deposit Ni/P to a thickness of approximately 5 µm.

The parts were rinsed and submerged into the following gold plating bath operated at 80° C. until a deposit thickness of approximately 0.1 µm was reached:

| | |
|---|---|
| Potassium gold cyanide | 1.2 g/L |
| Ethylenediaminetetraacetic acid sodium salt | 20 g/L |
| Glutaraldehyde bisulfite, sodium salt | 5 g/L |
| Sodium malate | 20 g/L |
| Balance D.I. water | |

The pH of the solution was adjusted to pH 8 with either sulfuric acid or potassium hydroxide.

The resulting gold deposit was bright and uniform. Upon inspecting the parts for hyper corrosion of the Ni/P layer, no corrosion was found on any of the features. The gold bath was stable and did not plate out of solution. The amount of nickel dissolved into the bath upon extended use demonstrated that at least some of the gold deposited onto the surface was deposited by autocatalytic reduction from solution and only a portion of the gold deposited was from immersion displacement with nickel.

### Example 2:

Circuit board test parts containing a 25 µm of copper were plated in an electroless nickel bath (Affinity 1.0, from MacDermid, Inc.) to deposit Ni/P to a thickness of approximately 5 µm, and a second deposit over the Ni/P was deposited from an electroless palladium bath (Affinity Pd, from MacDermid, Inc.) to a thickness of 0.05 µm. The parts were rinsed and submerged into the following gold plating bath until a deposit thickness of approximately 0.1 µm was reached:

| | |
|---|---|
| Potassium gold cyanide | 1.2 g/L |
| Ethylenediaminetetraacetic acid sodium salt | 20 g/L |
| Glutaraldehyde bisulfite, sodium salt | 5 g/L |
| Sodium malate | 20 g/L |
| Balance D.I. water | |

The pH of the solution was adjusted to pH 8 with either sulfuric acid or potassium hydroxide.

The resulting gold deposit was bright and uniform. Upon inspecting the parts for hyper corrosion of the Ni/P layer there was no corrosion found on any of the features. The gold bath was stable and did not plate out of solution.

### Example 3:

To the formulation in example 1, 10 g/L of Hydroxylethylethylendiamine was added to the solution. The same parts as in Example 1 were again plated in the gold at 80° C. until a deposit of approximately 0.1 µm was reached. The resulting gold deposit was bright and shiny. Again, no hyper corrosion of the Ni/P layer was evident. The gold bath was stable and did not plate out.

### Comparative Example 1:

The same tests were performed using a gold bath that does not contain an aldehyde reducing agent. The bath was an immersion gold bath (Affinity 1.0 from MacDermid, Inc.) that does not have any autocatalytic reduction of the gold. The same parts as in Example 1 were plated at 80° C. until a deposit of approximately 0.1 µm of gold was reached. Upon inspecting the parts, hyper corrosion of the Ni/P layer was observed due to the gold immersion reaction hyper corroding the Ni/P layer.

### Comparative Example 2:

A gold bath with the following formulation was prepared and tested for stability.

| | |
|---|---|
| Potassium gold cyanide | 1.2 g/L |
| Ethylenediaminetetraacetic acid sodium salt | 20 g/L |
| Formaldehyde bisulfite adduct | 5 g/L |
| Sodium malate | 20 g/L |
| Balance D.I. water | |

The pH of the solution was adjusted to pH 8 with either sulfuric acid or potassium hydroxide.

The bath was maintained at 80° C. 5 hours/day for 5 days. The bath was not stable and showed gold plate out at the bottom of the tank.

As shown in the Examples, plating baths utilizing the reducing agents described herein can be used to produce gold deposits that are more corrosion resistance and increased solderability as compared to plating baths of the prior art. The plating baths described herein also exhibit improved stability and do not plate out.

The electroless gold plating method described herein can be used for gold plating treatment, for example, of wiring circuit mounting portions or terminal portions of printed circuit boards, ceramic substrates, semiconductor substrates, and IC packages.

## Claims

1. An autocatalytic gold bath capable of depositing gold from solution onto a surface, the autocatalytic gold bath comprising:
a. a chelator, wherein the chelator is selected from phosphoric acid, boric acid, Rochelle salt, citric acid, gluconic acid, tartaric acid, lactic acid, malic acid, ethylenediamine, triethanolamine, ethylenediamine tetraacetic acid, nitrilotriacetic acid, diethylenetriamine pentaacetic acid, hydroxyethylethylenediamine triacetic acid, triethylenetetramine hexaacetic acid, 1,3-propanediamine tetraacetic acid, 1,3-diamino-2-hydroxypropane tetraacetic acid, hydroxyethylimino diacetic acid, dihydroxyl glycine, glycol ether diamine tetraacetic acid, dicarboxymethyl glutamic acid, hydroxyethylidene diphosphoric acid, ethylenediamine tetra(methylenephosphoric acid), and alkali metal salts, alkaline earth metal salts and ammonium salts of any of the foregoing, and combinations of the foregoing;
b. a gold salt, wherein the gold salt is a gold cyanide salt; and
c. a reducing agent, **characterized in that** the reducing agent is selected from 2-methoxybenzaldehyde sodium bisulfite addition compound, acetone sodium bisulfite addition compound, P-anisaldehyde sodium bisulfite addition compound, glutaraldehyde bisulfite addition compound, and combinations of one or more of the foregoing.

2. The autocatalytic gold bath according to claim 1, wherein the bath is maintained at a pH in the range of about 6 to about 9.

3. The autocatalytic gold bath according to claim 1, wherein the bath is maintained at a temperature in the range of about 75 to about 95° C.

4. The autocatalytic gold bath according to claim 1, wherein the autocatalytic bath further comprises an amine selected from ethylethylenediamine, diethylene triamine, triethylenetetramine, pentaethylenehexamine, and combinations thereof.

5. The autocatalytic bath according to claim 4, wherein a molar ratio between the reducing agent and the amine is between 1:10 to 1:1.

6. The autocatalytic gold bath according to claim 1, wherein the chelator comprises a sodium salt of ethylenediamine tetraacetic acid and sodium malate.

7. A method of providing a gold final finish on a substrate by autocatalytic gold plating, the method comprising the steps of:
a) providing a substrate with one or more metal layers thereon; and
b) contacting the one or more metal layers with a gold plating bath to deposit gold metal thereon, the gold plating bath comprising:
i) a chelator, wherein the chelator is selected from phosphoric acid, boric acid, Rochelle salt, citric acid, gluconic acid, tartaric acid, lactic acid, malic acid, ethylenediamine, triethanolamine, ethylenediamine tetraacetic acid, nitrilotriacetic acid, diethylenetriamine pentaacetic acid, hydroxyethylethylenediamine triacetic acid, triethylenetetramine hexaacetic acid, 1,3-propanediamine tetraacetic acid, 1,3-diamino-2-hydroxypropane tetraacetic acid, hydroxyethylimino diacetic acid, dihydroxyl glycine, glycol ether diamine tetraacetic acid, dicarboxymethyl glutamic acid, hydroxyethylidene diphosphoric acid, ethylenediamine tetra(methylenephosphoric acid), alkali salts, alkaline earth metal salts and ammonium salts of any of the foregoing, and combinations of the foregoing;
ii) a gold salt, wherein the gold salt is a gold cyanide salt; and
iii) a reducing agent, **characterized in that** the reducing agent is selected from 2-methoxybenzaldehyde sodium bisulfite addition compound, acetone sodium bisulfite addition compound, P-anisaldehyde sodium bisulfite addition compound, glutaraldehyde bisulfite addition compound, and combinations of one or more of the foregoing;
wherein the gold metal is deposited on the one or more metal layers, wherein the solderability of the one or more metal layers is increased.

8. The method according to claim 7, wherein the one or more metal layers comprise palladium and/or nickel.

9. The method according to claim 7, wherein the gold is plated onto an electroless nickel plated layer over copper features of a semiconductor substrate or printed circuit board, preferably wherein the electroless nickel layer comprises a palladium-plated film over the top of the nickel layer to prevent diffusion of the nickel layer to the gold deposit.

10. The method according to claim 7, wherein the gold plating bath deposits a final finish to the surface of the one or more metal layers, wherein the one or more metal layers are formed in an electroless nickel/immersion gold; electroless nickel, electroless palladium/immersion gold; electroless nickel autocatalytic gold; direct gold over copper; or gold over silver process.

11. The process according to claim 7, wherein the substrate is a circuit board and gold is deposited as a final finish to the one or more metal layers on the circuit board, wherein the deposited gold increases solderability of the one or more metal layers.

## Patentansprüche

1. Autokatalytisches Goldbad, das in der Lage ist, Gold aus einer Lösung auf eine Oberfläche abzuscheiden, das autokatalytische Goldbad umfassend:
a. einen Chelator, wobei der Chelator ausgewählt ist aus Phosphorsäure, Borsäure, Rochellesalz, Citronensäure, Gluconsäure, Weinsäure, Milchsäure, Äpfelsäure, Ethylendiamin, Triethanolamin, Ethylendiamintetraessigsäure, Nitrilotriessigsäure, Diethylentriaminpentaessigsäure, Hydroxyethylethylendiamintriessigsäure, Triethylentetraminhexaessigsäure, 1,3-Propandiamintetraessigsäure, 1,3-Diamino-2-hydroxypropantetraessigsäure, Hydroxyethyliminodiessigsäure, Dihydroxyglycin, Glykoletherdianintetraessigsäure, Dicarboxymethylglutaminsäure, Hydroxyethylidendiphosphorsäure, Ethylendiamintetra(methylenphosphorsäure) und Alkalimetallsalzen, Erdalkalimetallsalzen und Ammoniumsalzen von beliebigen der Vorangehenden und Kombinationen der Vorangehenden;
b. ein Goldsalz, wobei das Goldsalz ein Goldcyanidsalz ist; und
c. ein Reduktionsmittel, **dadurch gekennzeichnet, dass**
das Reduktionsmittel ausgewählt ist aus einer 2-Methoxybenzaldehydnatriumbisulfit-Additionsverbindung, einer Acetonnatriumbisulfit-Additionsverbindung, einer P-Anisaldehydnatriumbisulfit-Additionsverbindung, einer Glutaraldehydbisulfit-Additionsverbindung und Kombinationen von einer oder mehreren der Vorangehenden.

2. Autokatalytisches Goldbad nach Anspruch 1, wobei das Bad bei einem pH-Wert in dem Bereich von etwa 6 bis etwa 9 gehalten wird.

3. Autokatalytisches Goldbad nach Anspruch 1, wobei das Bad bei einer Temperatur in dem Bereich von etwa 75 °C bis etwa 95 °C gehalten wird.

4. Autokatalytisches Goldbad nach Anspruch 1, wobei das autokatalytische Bad ferner ein Amin umfasst, das ausgewählt ist aus Ethylethylendiamin, Diethylentriamin, Triethylentetramin, Pentaethylenhexamin und Kombinationen davon.

5. Autokatalytisches Bad nach Anspruch 4, wobei ein Molverhältnis zwischen dem Reduktionsmittel und dem Amin zwischen 1 : 10 bis 1 : 1 liegt.

6. Autokatalytisches Goldbad nach Anspruch 1, wobei der Chelator ein Natriumsalz von Ethylendiamintetraessigsäure und Natriummalat umfasst.

7. Verfahren zum Bereitstellen einer Goldendbehandlung auf einem Substrat durch autokatalytisches Goldplattieren, das Verfahren umfassend die Schritte:
a) Bereitstellen eines Substrats mit einer oder mehreren Metallschichten darauf; und
b) Inberührungbringen der einen oder der mehreren Metallschichten mit einem Goldplattierungsbad, um Goldmetall darauf abzuscheiden, das Goldplattierungsbad umfassend:
i) einen Chelator, wobei der Chelator ausgewählt ist aus Phosphorsäure, Borsäure, Rochellesalz, Zitronensäure, Gluconsäure, Weinsäure, Milchsäure, Äpfelsäure, Ethylendiamin, Triethanolamin, Ethylendiamintetraessigsäure, Nitrilotriessigsäure, Diethylentriaminpentaessigsäure, Hydroxyethylethylendiamintriessigsäure, Triethylentetraminehexaessigsäure, 1,3-Propandiamintetraessigsäure, 1,3-Diamino-2-hydroxypropantetraessigsäure, Hydroxyethyliminodiessigsäure, Dihydroxyglycin, Glykoletherdianintetraessigsäure, Dicarboxymethylglutaminsäure, Hydroxyethylidendiphosphorsäure, Ethylendiamintetra(methylenphosphorsäure), Alkalisalzen, Erdalkalimetallsalzen und Ammoniumsalzen von beliebigen der Vorangehenden und Kombinationen der Vorangehenden;
ii) ein Goldsalz, wobei das Goldsalz ein Goldcyanidsalz ist; und
iii) ein Reduktionsmittel, **dadurch gekennzeichnet, dass**
das Reduktionsmittel ausgewählt ist aus einer 2-Methoxybenzaldehydnatriumbisulfit-Additionsverbindung, einer Acetonnatriumbisulfit-Additionsverbindung, einer P-Anisaldehydnatriumbisulfit-Additionsverbindung, einer Glutaraldehydbisulfit-Additionsverbindung und Kombinationen von einer oder mehreren der Vorangehenden;
wobei das Goldmetall auf die eine oder die mehreren Metallschichten abgeschieden wird, wobei die Lötbarkeit der einen oder der mehreren Metallschichten erhöht wird.

8. Verfahren nach Anspruch 7, wobei die eine oder die mehreren Metallschichten Palladium und/oder Nickel umfassen.

9. Verfahren nach Anspruch 7, wobei das Gold auf eine stromlose vernickelte Schicht über Kupfermerkmalen eines Halbleitersubstrats oder einer gedruckten Leiterplatte plattiert wird, vorzugsweise wobei die stromlose Nickelschicht einen palladiumplattierten Film über der Oberseite der Nickelschicht umfasst, um eine Diffusion der Nickelschicht zu der Goldabscheidung zu verhindern.

10. Verfahren nach Anspruch 7, wobei das Goldplattierungsbad eine Endbehandlung auf die Oberfläche der einen oder der mehreren Metallschichten abscheidet, wobei die eine oder die mehreren Metallschichten in einem Prozess mit stromlosem Nickel/Immersionsgold; stromlosem Nickel/stromlosem Palladium/Immersionsgold; stromlosem Nickel/autokatalytischem Gold; Direktgold über Kupfer; oder Gold über Silber ausgebildet werden.

11. Prozess nach Anspruch 7, wobei das Substrat eine Leiterplatte ist und Gold als eine Endbehandlung auf die eine oder die mehreren Metallschichten auf der Leiterplatte abgeschieden wird, wobei das abgeschiedene Gold die Lötbarkeit der einen oder der mehreren Metallschichten erhöht.

## Revendications

1. Bain d'or autocatalytique capable de déposer de l'or à partir d'une solution sur une surface, le bain d'or autocatalytique comprenant :
a. un chélateur, dans lequel le chélateur est choisi parmi acide phosphorique, acide borique, sel de Rochelle, acide citrique, acide gluconique, acide tartrique, acide lactique, acide malique, éthylènediamine, triéthanolamine, acide éthylènediamine tétra-acétique, acide nitrilotriacétique, acide diéthylènetriamine penta-acétique, acide hydroxyéthyléthylènediamine triacétique, acide triéthylènetétramine hexa-acétique, acide 1,3-propanediamine tétra-acétique, acide 1,3-diamino-2-hydroxypropane tétra-acétique, acide hydroxyéthylimino diacétique, dihydroxylglycine, acide diamine tétra-acétique d'éther de glycol, acide dicarboxyméthylglutamique, acide hydroxyéthylidène diphosphorique, acide éthylènediamine tétra(méthylène phosphorique), et sels métalliques alcalins, sels métalliques alcalino-terreux et sels d'ammonium de l'un quelconque de ce qui précède, et combinaisons de ce qui précède ;
b. un sel d'or, dans lequel le sel d'or est un sel de cyanure d'or ; et
c. un agent réducteur, **caractérisé en ce que**
l'agent réducteur est choisi parmi le composé d'addition 2-méthoxybenzaldéhyde et de bisulfite de sodium, le composé d'addition d'acétone et de bisulfite de sodium, le composé d'addition de p-anisaldéhyde et de bisulfite de sodium, le composé d'addition de glutaraldéhyde et de bisulfite, et des combinaisons d'un ou plusieurs de ce qui précède.

2. Bain d'or autocatalytique selon la revendication 1, dans lequel le bain est maintenu à un pH dans la plage d'environ 6 à environ 9.

3. Bain d'or autocatalytique selon la revendication 1, dans lequel le bain est maintenu à une température dans la plage d'environ 75 à environ 95 °C.

4. Bain d'or autocatalytique selon la revendication 1, dans lequel le bain autocatalytique comprend en outre une amine choisie parmi éthyléthylènediamine, diéthylène triamine, triéthylènetétramine, pentaéthylènehexamine, et combinaisons de celles-ci.

5. Bain autocatalytique selon la revendication 4, dans lequel un rapport molaire entre l'agent réducteur et l'amine est compris entre 1:10 et 1:1.

6. Bain d'or autocatalytique selon la revendication 1, dans lequel le chélateur comprend un sel de sodium d'acide éthylènediamine tétra-acétique et de malate de sodium.

7. Procédé de fourniture d'une finition finale à l'or sur un substrat par placage d'or autocatalytique, le procédé comprenant les étapes consistant à :
a) fournir un substrat avec une ou plusieurs couches métalliques sur celui-ci ; et
b) mettre en contact la ou les couches métalliques avec un bain de placage d'or pour y déposer de l'or métallique, le bain de placage d'or comprenant :
i) un chélateur, dans lequel le chélateur est choisi parmi acide phosphorique, acide borique, sel de Rochelle, acide citrique, acide gluconique, acide tartrique, acide lactique, acide malique, éthylènediamine, triéthanolamine, acide éthylènediamine tétra-acétique, acide nitrilotriacétique, acide diéthylènetriamine penta-acétique, acide hydroxyéthyléthylènediamine triacétique, acide triéthylènetétramine hexa-acétique, acide 1,3-propanediamine tétra-acétique, acide 1,3-diamino-2-hydroxypropane tétra-acétique, acide hydroxyéthylimino diacétique, dihydroxylglycine, acide diamine tétra-acétique d'éther de glycol, acide dicarboxyméthylglutamique, acide hydroxyéthylidène diphosphorique, acide éthylènediamine tétra(méthylène phosphorique), sels alcalins, sels métalliques alcalino-terreux et sels d'ammonium de l'un quelconque de ce qui précède, et combinaisons de ce qui précède ;
ii) un sel d'or, dans lequel le sel d'or est un sel de cyanure d'or ; et
iii) un agent réducteur, **caractérisé en ce que**
l'agent réducteur est choisi parmi le composé d'addition 2-méthoxybenzaldéhyde et de bisulfite de sodium, le composé d'addition d'acétone et de bisulfite de sodium, le composé d'addition de p-anisaldéhyde et de bisulfite de sodium, le composé d'addition de glutaraldéhyde et de bisulfite, et des combinaisons d'un ou plusieurs de ce qui précède ;
dans lequel l'or métallique est déposé sur la ou les couches métalliques, dans lequel l'aptitude au brasage de la ou des couches métalliques est augmentée.

8. Procédé selon la revendication 7, dans lequel la ou les couches métalliques comprennent du palladium et/ou du nickel.

9. Procédé selon la revendication 7, dans lequel l'or est plaqué sur une couche plaquée de nickel anélectrolytique sur des caractéristiques en cuivre d'un substrat semi-conducteur ou d'une carte de circuit imprimé, de préférence dans lequel la couche de nickel anélectrolytique comprend un film plaqué de palladium par-dessus la couche de nickel pour empêcher la diffusion de la couche de nickel vers le dépôt d'or.

10. Procédé selon la revendication 7, dans lequel le bain de placage d'or dépose une finition finale sur la surface de la ou des couches métalliques, dans lequel la ou les couches métalliques sont formées dans un processus nickel anélectrolytique/or par immersion ; nickel anélectrolytique, palladium anélectrolytique/or par immersion ; nickel anélectrolytique or autocatalytique ; or direct sur cuivre ; ou processus or sur argent.

11. Procédé selon la revendication 7, dans lequel le substrat est une carte de circuit imprimé et de l'or est déposé en guise de finition finale sur la ou les couches métalliques sur la carte de circuit imprimé, dans lequel l'or déposé augmente l'aptitude au brasage de la ou des couches métalliques.
